# EUROPÄISCHE PATENTANMELDUNG

(11) **EP 0 736 540 A2**
(43) Veröffentlichungstag der Anmeldung: **09.10.1996**
(21) Anmeldenummer: 96107166.9
(22) Anmeldetag: 27.07.1990
(51) Int. Cl.: C07F 9/53, C07F 9/6568, C08F 2/50, G03F 7/027, G03F 1/02, G03F 7/029

(54) **Mono- und Diacylphosphinoxide**

(30) Priorität: 04.08.1989 CH 2897/89
(62) Teilanmeldung aus: 90810574.5
(71) Anmelder: CIBA-GEIGY AG, 4002 Basel (CH)
(72) Erfinder: Rutsch, Werner, Dr., 1700 Fribourg (CH); Dietliker, Kurt, Dr., 1700 Fribourg (CH); Hall, Roger Graham, Dr., 4147 Aesch (CH)

(57) **Zusammenfassung**

Verbindungen der Formel I, 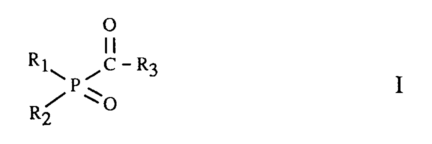 worin mindestens einer der Reste R₁ und R₃ ein substituierter Alkylrest oder Cycoalkylrest ist oder R₁ und R₂ zusammen mit dem Phosphoratom einen mono- oder tricyclischen Ring bilden, sind wirkungsvolle Photoinitiatoren für die Photopolymerisation von ethylenisch ungestättigten Verbindungen.

## Beschreibung

Die Erfindung betrifft spezielle Mono- und Diacylphosphinoxide sowie deren Verwendung als Photoinitiatoren für die Photopolymerisation von ethylenisch ungesättigten Verbindungen.

Monoacylphosphinoxide sind als Photoinitiatoren bekannt aus der EP-A-7508. Bisacylphosphinoxide und ihre Verwendung als Photoinitiatoren sind bekannt aus der EP-A-184 095. Es wurden nunmehr neue Mono- und Bisacylphosphinoxide gefunden, die sich von den bekannten Verbindungen durch das Vorhandensein bestimmter Substituenten unterscheiden. Es handelt sich dabei um Verbindungen der Formel I, 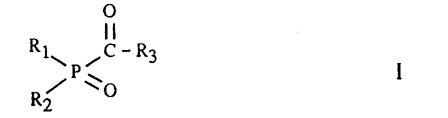 worin R₁ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, einen ein oder mehrere O-, S- oder/und N-Atome enthaltenden 5- oder 6-gliedrigen heterocyclischen einwertigen Rest, der gegebenenfalls einen anellierten Benzorest enthält oder/und der unsubstituiert oder durch C₁-C₄-Alkyl, C₁-C₄-Alkoxy oder/und Halogen substituiert ist oder einen Rest der Formel 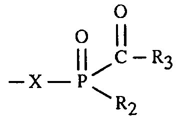 bedeutet, worin X unsubstituiertes oder mit Halogen, C₁-C₄-Alkyl, C₁-C₄-Alkoxy oder Phenyl ein- oder mehrfach substituiertes Phenylen, Xylylen, Cyclohexylen, C₁-C₆-Alkylen, bedeutet,
R₂ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅-Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, einen ein oder mehrere O-, S- oder N-Atome enthaltenden 5- oder 6-gliedrigen heterocyclischen einwertigen Rest, der gegebenenfalls einen anellierten Benzorest enthält oder/und der unsubstituiert oder durch C₁-C₄-Alkyl, C₁-C₄-Alkoxy oder/und Halogen substituiert ist, oder einen Rest -CO-R₃ oder -OR₄ bedeutet, oder R₁ und R₂ oder R₁ und R₄ zusammen mit dem Phosphoratom einen mono- oder bi- oder tricyclischen Ring mit 4-15 C-Atomen bilden,
R₃ C₁-C₁₈-Alkyl, C₂-C₆-Alkenyl, Phenylvinyl, mit Phenyl, C₂-C₅-Alkoxycarbonyl, Halogen, C₁-C₁₂-Alkoxy, Phenoxy, C₁-C₁₂-Alkylthio oder/und Phenylthio ein- oder mehrfach substituiertes C₁-C₈-Alkyl, unsubstituiertes oder durch C₁-C₁₂-Alkyl, Phenyl, Phenoxy, C₁-C₁₂-Alkoxy, C₂-C₅-Alkoxycarbonyl, C₁-C₄-Alkylthio oder/und Halogen substituiertes C₅-C₁₀-Cycloalkyl, unsubstituiertes oder durch C₁-C₁₂-Alkyl, C₁-C₁₂-Alkoxy, C₁-C₁₂-Alkoxyalkyl, C₁-C₄-Alkylthio oder/und Halogen ein- oder mehrfach substituiertes C₆-C₁₂-Aryl oder einen einwertigen 5- oder 6-gliedrigen ein oder mehrere O-, S- oder N-Atome enthaltenden heterocyclischen Rest bedeutet, welcher durch Halogen, C₁-C₄-Alkyl oder C₁-C₄-Alkoxy ein- oder mehrmals substituiert sein kann, und
R₄ C₁-C₁₈-Alkyl, Phenyl-C₁-C₄-alkyl, C₅-C₈-Cycloalkyl oder C₆-C₁₀-Aryl bedeutet, mit der Bestimmung, dass mindestens einer der Reste R₁, R₂ und R₃ ein substituierter Alkylrest ist oder dass R₁ und R₂ zusammen mit dem Phosphoratom einen bi- oder tricyclischen Ring bilden, oder dass R₃ ein substituierter Cycloalkylrest ist der jedoch Alkylreste nicht als alleinige Substituenten enthalten kann.

R₁, R₂, R₃ und R₄ als C₁-C₁₈-Alkyl können verzweigtes oder unverzweigtes Alkyl sein und können z.B. Methyl, Ethyl, Propyl, Isopropyl, n-Butyl, sec-Butyl, tert-Butyl, Pentyl, Hexyl, Heptyl, Octyl, 2-Ethylhexyl, 2,4,4-Trimethylpentyl, Decyl, Dodecyl, Tetradecyl, Heptadecyl oder Octadecyl sein.

R₃ als Alkyl ist vorzugsweise tertiäres Alkyl, wie z.B. tert.Butyl, 1,1-Dimethylpropyl, 1,1-Dimethylbutyl oder 1,1,3,3-Tetramethylbutyl.

R₁ und R₂ als C₂-C₁₈-Alkenyl können z.B. Vinyl, Allyl, Methallyl, 1,1-Dimethylallyl, 2-Butenyl, 2-Hexenyl, Octenyl, Undecenyl, Dodecenyl oder Octadecenyl sein. R₄ als C₂-C₁₈-Alkenyl kann darüberhinaus auch Vinyl sein.
R₃ als C₂-C₆-Alkenyl kann z.B. Vinyl, Propenyl oder Butenyl sein.

R₁ und R₂ als ein- oder mehrfach, z.B. ein- bis 3-fach, insbesondere ein- oder zweifach, substituiertes C₁-C₈-Alkyl kann z.B. Benzyl, 1-Phenylethyl, 2-Phenylethyl, α,α-Dimethylbenzyl, Benzhydryl, p-Tolylmethyl, 1-(p-Butylphenyl)-ethyl, p-Chlorbenzyl, 2,4-Dichlorbenzyl, p-Methoxybenzyl, m-Ethoxybenzyl, 2-Cyanoethyl, 2-Cyanopropyl, 2-Methoxycarbonylethyl, 2-Ethoxycarbonylethyl, 2-Butoxycarbonylpropyl, 1,2-Di(methoxycarbonyl)-ethyl, 2-Methoxyethyl, 2-Ethoxyethyl, 2-Butoxyethyl, Diethoxymethyl, Diethoxyethyl, 1,3-Dioxolan-2-yl, 1,3-Dioxan-2-yl, 2-Methyl-1,3-dioxolan-2-yl, 4-Methyl-1,3-dioxolan-2-yl, 2-Isopropoxyethyl, 2-Butoxypropyl, 2-Octyloxyethyl, Chlormethyl, 2-Chlorethyl, Trichlormethyl oder Trifluormethyl, bevorzugt Benzyl sein.

R₃ als ein- oder mehrfach, z.B. ein- bis 3-fach, insbesondere ein- oder zweifach, substituiertes C₁-C₈-Alkyl kann z.B. Benzyl, Phenylethyl, α,α-Dimethylbenzyl, Benzhydryl, 1,1-Dichlorethyl, Trichlormethyl, Trifluormethyl, 1,1-Dimethyl-2-chlorethyl, 2-Methoxyisopropyl, 2-Ethoxyethyl, Butylthiomethyl, 2-Dodecylthioethyl oder 2-Phenylthioethyl sein.

R₄ als ein- oder mehrfach, z.B. ein- bis 3-fach, insbesondere ein- oder zweifach, substituiertes C₁-C₈-Alkyl kann z.B. Benzyl, 2-Phenylethyl, 3-Phenylpropyl, 2-Methoxyethyl, 2-Butoxyethyl, 2-Hexyloxyethyl, 2-Isopropoxypropyl, 2-Chlorethyl oder 2,2,2-Trifluorethyl sein.

R₁, R₂, R₃ und R₄ als C₅-C₈-Cycloalkyl können z.B. Cyclopentyl, Cyclohexyl oder Cyclooctyl sein. R₃ als substituiertes z.B. ein- bis 4-fach C₅-C₁₀-Cycloalkyl kann z.B. Methylcyclopentyl, Dimethylcyclopentyl, Methylcyclohexyl, Dimethylcyclohexyl, Diethylcyclohexyl, Butylcyclohexyl, Methoxycyclohexyl, Dimethoxycyclohexyl, Diethoxycyclohexyl, Butylthiocyclohexyl, Chlorcyclohexyl, Dichlorcyclohexyl oder Dichlorcyclopentyl sowie ein gesättigtes oder ungesättigtes bicyclisches System wie z.B. Norbornyl oder Norbornenyl sein.

R₁, R₂, R₃ und R₄ als C₆-C₁₂-Aryl können z.B. Phenyl, α-Naphthyl, β-Naphthyl oder 4-Diphenylyl, insbesondere Phenyl, sein. R₁, R₂ und R₃ als substituiertes C₆-C₁₂-Aryl können z.B. Chlorphenyl, Dichlorphenyl, Trichlorphenyl, Difluorphenyl, Tolyl, Ethylphenyl, tert.Butylphenyl, Dodecylphenyl, Methoxyphenyl, Dimethoxyphenyl, Ethoxyphenyl, Hexyloxyphenyl, Methylnaphthyl, Isopropylnaphthyl, Chlornaphthyl oder Ethoxynaphthyl sein. R₃ als substituiertes Aryl kann darüber hinaus auch z.B. Methoxyethylphenyl, Ethoxymethylphenyl, Methylthiophenyl, Isopropylthiophenyl oder tert.Butylthiophenyl sein. Auch substituiertes Aryl ist vorzugsweise substituiertes Phenyl.

R₁, R₂ und R₃ als heterocyclischer Rest können z.B. Furyl, Thienyl, Pyrryl, Pyridyl, Indolyl, Benzoxazolyl, Dioxolyl, Dioxyl, Benzimidazolyl oder Benzthiazolyl sein. Bevorzugt enthält ein solcher heterocyclischer Rest 3-12, insbesondere 3-5 C-Atome. Substituierte (z.B. mit 1-3, insbesondere 1 oder 2 Substituenten) heterocyclische Reste sind z.B. Dimethylpyridyl, Methylchinolyl, Dimethylpyrryl, Methoxyfuryl, Dimethoxypyridyl oder Difluorpyridyl.

X als C₁-C₆-Alkylen kann z.B. Methylen, 1,2-Ethylen, 2,2-Dimethyl-1,3-propylen, Tri-, Tetra-, Penta- und Hexamethylen oder Phenylmethylen sein.

Wenn R₁ und R₂ zusammen mit dem P-Atom einen monocyclischen Ring bilden, so ist dies vorzugsweise ein Phosphacyclopentanring.
Wenn R₁ und R₂ zusammen mit dem P-Atom einen bicyclischen Ring bilden, so ist dies vorzugsweise ein Phospha-bicyclohexan- oder -bicyclononanring.

Wenn R₁ und R₄ zusammen mit dem P-Atom einen tricyclischen Ring bilden, so ist dies vorzugsweise ein (6H)-Dibenz[c,e][1,2]-oxaphosphorinring.

Bevorzugt sind Verbindungen der Formel I, worin
R₁ C₁-C₁₂-Alkyl, durch Phenyl, (C₁-C₄-Alkyl)-phenyl, Chlorphenyl, (C₁-C₄-Alkoxy)-phenyl oder/und C₁-C₄-Alkoxy ein- bis dreifach substituiertes C₁-C₄-Alkyl, Cyclohexyl, C₆-C₁₀-Aryl oder durch Chlor, C₁-C₁₂-Alkyl oder/und C₁-C₄-Alkoxy ein- bis dreifach substituiertes C₆-C₁₀-Aryl oder einen ein oder mehrere O-, S-, oder N-Atome enthaltenden 5- oder 6-gliedrigen heterocyclischen einwertigen Rest bedeutet,
R₂ eine der für R₁ gegebenen Bedeutungen hat oder ein Rest -CO-R₃ oder -OR₄ ist oder R₁ und R₂ oder R₁ und R₄ zusammen mit dem P-Atom einen mono- oder bicyclischen Rest mit 4-8 C-Atomen bilden,
R₃ C₁-C₈-Alkyl, mit Phenyl, C₁-C₄-Alkoxy, C₂-C₅-Alkoxycarbonyl oder/und Chlor ein- oder zweifach substituiertes C₁-C₆-Alkyl, unsubstituiertes oder durch Phenyl, C₁-C₄-Alkoxy, C₂-C₅-Alkoxycarbonyl oder/und Chlor substituiertes C₅-C₆-Cycloalkyl, C₆-C₁₀-Aryl oder durch C₁-C₁₂-Alkyl, C₁-C₄-Alkoxy oder/und Chlor ein- bis dreifach substituiertes C₆-C₁₀-Aryl bedeutet und R₄ C₁-C₈-Alkyl, Cyclohexyl, Benzyl oder Phenyl ist,
insbesondere worin R₁ C₁-C₈-Alkyl, durch Phenyl, (C₁-C₄-Alkyl)-phenyl oder C₁-C₄-Alkoxy ein- oder zweifach substituiertes C₁-C₄-Alkyl, Cyclohexyl, Phenyl oder durch C₁-C₄-Alkyl oder C₁-C₄-Alkoxy ein- bis dreifach substituiertes Phenyl bedeutet,
R₂ eine der für R₁ gegebenen Bedeutungen hat oder ein Rest -CO-R₃ oder -OR₄ ist oder R₁ und R₂ oder R₁ und R₄ zusammen mit dem P-Atom einen mono- oder bicyclischen Ring bilden,
R₃ unsubstituiertes oder durch Phenyl, Chlor oder/und C₁-C₄-Alkoxy substituiertes C₁-C₆-Alkyl, unsubstituiertes oder durch Phenyl, C₁-C₄-Alkoxy, C₂-C₅-Alkoxycarbonyl oder/und Chlor substituiertes C₅-C₆-Cycloalkyl, Phenyl oder durch C₁-C₄-Alkyl, C₁-C₄-Alkoxy oder/und Chlor ein- bis dreifach substituiertes Phenyl bedeutet und
R₄ C₁-C₄-Alkyl, Cyclohexyl oder Phenyl bedeutet.

Bevorzugt ist R₁ ein wie oben definierter substituierter Alkylrest, insbesondere durch Phenyl, (C₁-C₄-Alkyl)-phenyl, oder C₁-C₄-Alkoxy ein- bis zweifach substituiertes C₁-C₄-Alkyl, besonders bevorzugt ist Benzyl.

R₃ ist insbesondere ein Phenylrest, der in beiden Orthostellungen durch C₁-C₄-Alkyl, C₁-C₄-Alkoxy oder Chlor substituiert ist.

Bevorzugt sind ferner bicyclische Verbindungen der Formel II oder III 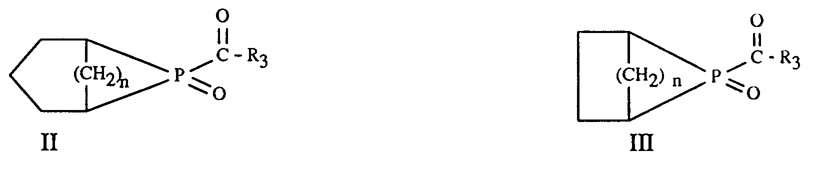 worin n 1-8 ist und R₃ eine der oben gegebenen Bedeutungen hat, insbesondere solche Verbindungen der Formel II oder III, worin n 1-8, insbesondere 1-4, ist und R₃ durch Phenyl substituiertes C₁-C₄-Alkyl, C₆-C₁₀-Aryl oder durch C₁-C₁₂-Alkyl, C₁-C₄-Alkoxy, oder Chlor ein- bis dreifach substituiertes Phenyl bedeutet.

Beispiele für einzelne Verbindungen der Formel I sind:
Dibenzyl-(2,4,6-trimethylbenzoyl)-phosphinoxid
Bis(2-phenylethyl)-(2,6-dichlorbenzoyl)-phosphinoxid
Bis(2-phenylpropyl)-(2,6-dimethoxybenzoyl)-phosphinoxid
Bis(2-phenylpropyl)-(2,4,6-trimethylbenzoyl)-phosphinoxid
Bis(2-cyanoethyl)-(2,4,6-trimethylbenzoyl)-phosphinoxid
2-Phenylpropyl-(2,4,6-trimethylbenzoyl)-phosphinsäuremethylester
6-[Bis(chlormethyl)propionyl]-(6H)-dibenz[c,e][1,2]-oxaphosphorin-6-oxid
Phenyl-(2,2-dimethyl-3-phenylpropionyl)-phosphinsäuremethylester
Diphenyl-(2,2-dimethyl-3-phenylpropionyl)-phosphinoxid
Diphenyl-2,6-dimethoxycyclohexanoyl-phosphinoxid
Dibutyl-(2-methyl-2-phenylbutyryl)-phosphinoxid
Butyl-1,1-diethoxyethyl-2,4,6-trimethylbenzoyl-phosphinoxid
Bis(cyclohexyl)-(2-methyl-2-phenylthiopropionyl)-phosphinoxid
Diphenyl-(2-octyloxy-2-phenylpropionyl)-phosphinoxid
1-(2,6-Dimethylbenzoyl)-phospholan-1-oxid
6-(2,6-Dichlorbenzoyl)-6-phosphabicyclo[2.1.1]hexan-6-oxid
9-(2,6-Dichlorbenzoyl)-9-phosphabicyclo[3.3.1]nonan-9-oxid
9-(2,4,6-Trimethylbenzoyl)-9-phosphabicyclo[4.2.1]nonan-9-oxid
Bis(2,6-dichlorbenzoyl)-2-phenylpropylphosphinoxid
Bis(2,6-dimethoxybenzoyl)-benzylphosphinoxid
Bis(2,6-dimethoxybenzoyl)-2-phenylpropylphosphinoxid
Bis(2,6-dimethoxybenzoyl)-2-phenylethylphosphinoxid
Bis(2,6-dichlorbenzoyl)-benzylphosphinoxid
Bis(2,6-dichlorbenzoyl)-2-phenylethlphosphinoxid
Bis(2,4,6-trimethylbenzoyl)-benzylphosphinoxid
Bis(2,4,6-trimethylbenzoyl)-2-phenylpropylphosphinoxid
Bis(2,4,6-trimethylbenzoyl)-2-phenylethylphosphinoxid
Bis(2,4,6-trimethylbenzoyl)-2-cyanoethylphosphinoxid
Bis(2,6-dichlorbenzoyl)-2-cyanoethylphosphinoxid
Bis(2,6-dimethoxybenzoyl)-2-cyanoethylphosphinoxid
Bis(2-methylthiobenzoyl)-2-phenylpropylphosphinoxid
Bis(2-methyl-1-naphthoyl)-2-phenylpropylphosphinoxid
Bis(2-methyl-2-phenylpropionyl)-cyclohexylphosphinoxid
Bis(2-methyl-2-phenylbutyryl)-phenylphosphinoxid
Bis(2,2-dimethyl-4-phenylbutyryl)-phenylphosphinoxid
Bis(2-methoxy-2-phenylbutyryl)-4-propylphenylphosphinoxid
Bis(2-methylthio-2-phenylbutyryl)-cyclohexylphosphinoxid
Bis(2-methyl-2-phenylthiopropionyl)-2-phenylpropylphosphinoxid
Bis(2-methyl-2-phenylbutyryl)-2-phenylpropylphosphinoxid
Bis(2-methyl-2-phenylbutyryl)-2-cyclohexylphosphinoxid
(2,6-Dichlorbenzoyl)-(1,3-dioxolan-2-yl)-phenylphosphinoxid
Diphenyl-(3-phenyl-bicyclo[2.2.1]hept-5-en-2-ylcarbonyl)-phosphinoxid
Diphenyl(2-methyl-3-phenyl-bicyclo[2.2.1]heptan-2-ylcarbonyl)-phosphinoxid
2,4,6-Trimethylbenzoyl-benzyl-butylphosphinoxid
2,6-Dichlorbenzoyl-benzyl-butylphosphinoxid
2,6-Dimethoxybenzoyl-benzyl-butylphosphinoxid
2,6-Dimethoxybenzoyl-benzyl-octylphosphinoxid
2,6-Dichlorbenzoyl-benzyl-octylphosphinoxid
2,4,6-Trimethylbenzoyl-benzyl-octylphosphinoxid
2,4,6-Trimethylbenzoyl-benzyl-methylphosphinoxid
2,4,6-Trimethylbenzoyl-benzyl-cyclohexylphosphinoxid
2,6-Dichlorbenzoyl-benzyl-cyclohexylphosphinoxid
2,6-Dimethoxybenzoyl-benzyl-cyclohexylphosphinoxid

Die Verbindungen der Formel I, worin R₂ ein Rest -OR₄ ist, können hergestellt werden durch eine Arbusow-Michaelis-Reaktion des entsprechenden Phosphonites IV mit einem Carbonsäurechlorid V nach dem Schema:

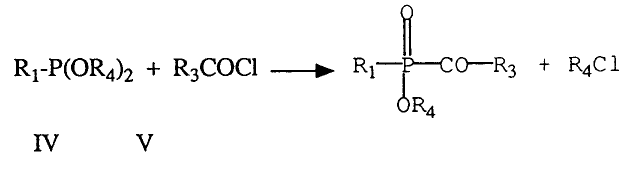

Die Umsetzung kann mit oder ohne Lösungsmittel erfolgen. Sofern die Komponenten IV und V flüssig sind, arbeitet man vorzugsweise ohne Lösungsmittel. Geeignete Lösungsmittel sind vor allem Kohlenwasserstoffe wie Alkane und Alkangemische, Benzol, Toluol oder Xylol. Die Reaktion wird vorzugsweise bei 20-120°C ausgeführt. Das entstehende R₄Cl wird vorzugsweise während der Reaktion laufend abdestilliert. Falls ein Lösungsmittel verwendet wird, wird dieses am Ende der Reaktion abdestilliert. Das rohe Reaktionsprodukt kann z.B. durch Destillation, Kristallisation oder Chromatographie gereinigt werden.

Die Phosphonite IV können in bekannter Weise durch Umsetzung eines Dichlorphosphines R₁-PCl₂ mit mindestens 2 Mol R₄OH in Gegenwart eines HCl-Akzeptors hergestellt werden (siehe dazu Houben-Weyl, Methoden d. Org. Chemie XII/1 324-327 (1963), G. Thieme-Verlag, Stuttgart).

Die Verbindungen der Formel I, worin R₂ ein Rest -COR₃ ist, können hergestellt werden durch doppelte Acylierung eines primären Phosphins VI mit mindestens 2 Aequivalenten eines Säurechlorides V in Gegenwart von mindestens 2 Aequivalenten einer Base und anschliessende Oxydation des erhaltenen Diacylphosphins VII zum Phosphinoxid nach dem Schema:

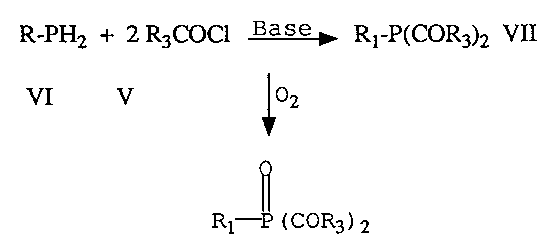

Als Base eignen sich z.B. tertiäre Amine, Alkalimetalle, Lithiumdiisopropylamid, Alkalialkoholate oder Alkalihydride. Die erste Reaktionsstufe geschieht vorzugsweise in Lösung. Als Lösungsmittel sind vor allem Kohlenwasserstoffe geeignet, wie z.B. Alkane, Benzol, Toluol oder Xylol. Nach Abtrennen des gebildeten Basenchlorides kann das Phosphin VII durch Eindampfen isoliert werden oder man führt die zweite Reaktionsstufe ohne Isolierung von VII mit der Lösung des Rohproduktes durch. Als Oxidationsmittel für die zweite Stufe eignen sich vor allem Wasserstoffperoxid und organische Peroxyverbindungen, beispielsweise Peressigsäure.

Die als Ausgangsmaterial benutzten primären Phosphine VI sind bekannte Verbindungen oder können in Analogie zu bekannten Verbindungen hergestellt werden (siehe dazu Houben-Weyl, Methoden der Org. Chemie XII/1, 60-63 (1963), G. Thieme-Verlag, Stuttgart).

Die Verbindungen der Formel I, worin R₂ weder ein Rest -OR₄ noch ein Rest -COR₃ ist, können hergestellt werden durch Acylierung von sekundären Phosphinen VIII und anschliessende Oxidation nach dem Schema:

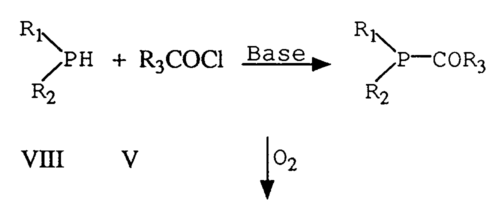

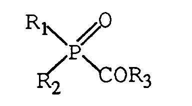

Für diese Reaktionen gilt dasselbe wie oben gesagt. Die Ausgangsphosphine VIII können nach bekannten Methoden erhalten werden, beispielsweise durch Reduktion von Monochlorphosphinen (R₁)(R₂)PCl mittels LiAlH₄ (siehe dazu Houben-Weyl, Methoden der Org. Chemie XII/1, 60-63 (1963), G. Thieme-Verlag, Stuttgart).

Eine alternative Herstellungsmöglichkeit ist die Arbusow-Michaelis-Reaktion von Phosphiniten IX mit V nach dem Schema:

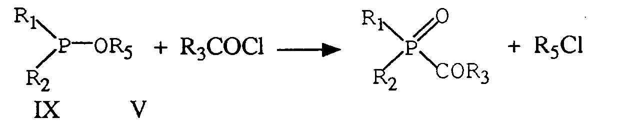

Hierin bedeutet R₅ einen Alkylrest.

Die Ausgangsmaterialien IX können nach bekannten Methoden hergestellt werden, beispielsweise durch Alkoholyse von Monochlorphosphinen (R₁)(R₂)PCl mit R₅OH in Gegenwart von Basen (siehe dazu Houben-Weyl, Methoden der Org. Chemie XII/1, 208-210 (1963), G. Thieme-Verlag, Stuttgart).

Erfindungsgemäss können die Verbindungen der Formel I als Photoinitiatoren für die Photopolymerisation von ethylenisch ungesättigten Verbindungen bzw. Gemischen, die solche Verbindungen enthalten, verwendet werden. Die ungesättigten Verbindungen können eine oder mehrere olefinische Doppelbindungen enthalten. Sie können niedermolekular (monomer) oder höhermolekular (oligomer) sein. Beispiele für Monomere mit einer Doppelbindung sind Alkyl- oder Hydroxyalkyl-acrylate oder -methacrylate, wie z.B. Methyl-, Ethyl-, Butyl-, 2-Ethylhexyl- oder 2-Hydroxyethylacrylat, Isobornylacrylat, Methyl- oder Ethylmethacrylat. Weitere Beispiele hierfür sind Acrylnitril, Acrylamid, Methacrylamid, N-substituierte (Meth)acrylamide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylenglykol-, Neopentylglykol-, Hexamethylenglykol- oder Bisphenol-A-diacrylat, 4,4'-Bis(2-acryloyloxyethoxy)-diphenylpropan, Trimethylolpropan-triacrylat, Pentaerythrit-triacrylat oder -tetraacrylat, Vinylacrylat, Divinylbenzol, Divinylsuccinat, Diallylphthalat, Triallylphosphat, Triallylisocyanurat oder Tris-(2-acryloylethyl)isocyanurat.

Beispiele für höhermolekulare (oligomere) mehrfach ungesättigte Verbindungen sind acrylierte Epoxidharze, acrylierte Polyether, acrylierte Polyurethane oder acrylierte Polyester. Weitere Beispiele für ungesättigte Oligomere sind ungesättigte Polyesterharze, die meist aus Maleinsäure, Phthalsäure und einem oder mehreren Diolen hergestellt werden und Molekulargewichte von etwa 500 bis 3000 besitzen. Solche ungesättigte Oligomere kann man auch als Prepolymere bezeichnen.

Häufig verwendet man Zweikomponenten-Gemische eines Prepolymeren mit einem mehrfach ungesättigten Monomeren oder Dreikomponentengemische, die ausserdem noch ein einfach ungesättigtes Monomer enthalten. Das Prepolymere ist hierbei in erster Linie für die Eigenschaften des Lackfilmes massgebend, durch seine Variation kann der Fachmann die Eigenschaften des gehärteten Filmes beeinflussen. Das mehrfach ungesättigte Monomere fungiert als Vernetzer, das den Lackfilm unlöslich macht. Das einfach ungesättigte Monomere fungiert als reaktiver Verdünner, mit dessen Hilfe die Viskosität herabgesetzt wird, ohne dass man ein Lösungsmittel verwendet muss.

Solche Zwei- und Dreikomponentensysteme auf der Basis eines Prepolymeren werden sowohl für Druckfarben als auch für Lacke, Photoresists oder andere photohärtbare Massen verwendet. Als Bindemittel für Druckfarben werden vielfach auch Einkomponenten-Systeme auf der Basis photohärtbarer Prepolymerer verwendet.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensysteme verwendet, wie z.B. Polymaleinimide, Polychalkone oder Polyimide, wie sie in der DE-OS 2 308 830 beschrieben sind.

Die ungesättigten Verbindungen können auch im Gemisch mit nicht-photopolymerisierbaren filmbildenden Komponenten verwendet werden. Diese können z.B. physikalisch trocknende Polymere bzw. deren Lösungen in organischen Lösungsmitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Die photopolymerisierbaren Gemische können ausser dem Photoinitiator verschiedene Additive enthalten. Beispiele hierfür sind thermische Inhibitoren, die eine vorzeitige Polymerisation verhindern sollen, wie z.B. Hydrochinon oder sterisch gehinderte Phenole. Zur Erhöhung der Dunkellagerstabilität können z.B. Kupferverbindungen, Phosphorverbindungen, quartäre Ammoniumverbindungen oder Hydroxylaminderivate verwendet werden. Zwecks Ausschluss des Luftsauerstoffes während der Polymerisation kann man Paraffin oder ähnliche wachsartige Stoffe zusetzen, die bei Beginn der Polymerisation an die Oberfläche wandern. Als Lichtschutzmittel können in geringer Menge UV-Absorber, wie z.B. solche vom Benztriazol-, Benzophenon- oder Oxalanilid-Typ, zugesetzt werden. Noch besser ist der Zusatz von Lichtschutzmitteln, die UV-Licht nicht absorbieren, wie z.B. von sterisch gehinderten Aminen (HALS).

In bestimmten Fällen kann es von Vorteil sein, Gemische von zwei oder mehr der erfindungsgemässen Photoinitiatoren zu verwenden. Selbstverständlich können auch Gemische mit bekannten Photoinitiatoren verwendet werden, z.B. Gemische mit Benzophenon, Acetophenonderivaten, Benzoinethern oder Benzilketalen.

Zur Beschleunigung der Photopolymerisation können Amine zugesetzt werden, wie z.B. Triethanolamin, N-Methyl-diethanolamin, p-Dimethylaminobenzoesäure-ethylester oder Michlers Keton. Die Wirkung der Amine kann verstärkt werden durch den Zusatz von aromatischen Ketonen vom Typ des Benzophenons.

Eine Beschleunigung der Photopolymerisation kann weiterhin durch Zusatz von Photosensibilisatoren geschehen, welche die spektrale Empfindlichkeit verschieben bzw. verbreitem. Dies sind insbesondere aromatische Carbonylverbindungen wie z.B. Benzophenon-, Thioxanthon-, Anthrachinon- und 3-Acylcumarinderivate sowie 3-(Aroylmethylen)-thiazoline.

Weitere übliche Zusätze sind - je nach Verwendungszweck - Füllstoffe, Pigmente, Farbstoffe, Netzmittel oder Verlaufhilfsmittel.

Die Erfindung betrifft daher auch photopolymerisierbare Zusammensetzungen, enthaltend
a) mindestens eine ethylenisch ungesättigte photopolymerisierbare Verbindung und
b) als Photoinitiator mindestens eine Verbindung der Formel I,
wobei die Zusammensetzung ausserdem noch einen anderen Photoinitiator und/oder andere Additive enthalten kann.

Die photopolymerisierbaren Zusammensetzungen enthalten den Photoinitiator (b) zweckmässig in einer Menge von 0,05 bis 15 Gew.-%, vorzugsweise 0,2 bis 5 Gew.-%, bezogen auf die Zusammensetzung.

Die photopolymerisierbaren Zusammensetzungen können für verschiedene Zwecke verwendet werden, beispielsweise als Druckfarbe, als Weisslack, als Anstrichstoff, als Anstrichstoff für Aussenanstriche, für photographische Reproduktionsverfahren, für Bildaufzeichnungsverfahren oder zur Herstellung von Druckplatten, als Zahnfüllmassen, als Klebstoffe, als Ueberzüge von optischen Fasern, für gedruckte Schaltungen oder zur Beschichtung von elektonischen Teilen.

Die Polymerisation erfolgt nach den bekannten Methoden der Photopolymerisation durch Bestrahlung mit Sonnenlicht oder mit Licht, das reich an kurzwelliger Strahlung ist. Als Lichtquellen sind z.B. Quecksilbermitteldruck-, -hochdruck- und -niederdruckstrahler, superaktinische Leuchtstoffröhren, Metallhalogenid-Lampen oder Laser geeignet, deren Emissionsmaxima im Bereich zwischen 250 und 450 nm liegen. Im Falle einer Kombination mit Photosensibilisatoren können auch längerwelliges Licht oder Laserstrahlen bis 600 nm verwendet werden.

Die nachfolgenden Beispiele erläutern die Erfindung weiter. Angaben in Teilen oder Prozenten beziehen sich, ebenso wie in der übrigen Beschreibung und in den Patentansprüchen, auf das Gewicht, sofern nichts anderes angegeben ist.

### Beispiel 1 Herstellung von Bis(2-phenylpropyl)-(2,6-dimethoxybenzoyl)-phosphinoxid

Zu einer Lösung aus 1,1 g (0,011 Mol) Diisopropylamin in 10 ml absolutem Tetrahydrofuran (THF) werden unter Argon bei 0°C 6,9 ml (0,011 Mol, 1,6 M) Butyllithium innerhalb 10 Minuten zugetropft.
Diese Lösung wird bei -20 bis -30°C innerhalb ca. 40 Minuten zu einer Lösung aus 2,2 g (0,011 Mol) 2,6-Dimethoxybenzoylchlorid und 2,7 g (0,01 Mol) Bis(2-phenylpropyl)-phosphin in 20 ml absolutem THF getropft.
Nach 2 h rühren bei -30°C lässt man die gelbe Lösung auf Raumtemperatur erwärmen, verdünnt mit 100 ml Toluol und wäscht einmal mit Wasser und einmal mit gesättigter Natriumbicarbonatlösung. Die organische Phase wird mit Magnesiumsulfat getrocknet, filtriert und am Rotationsverdampfer eingeengt. Der Rückstand wird in 40 ml Acetonitril gelöst und mit 1,1 g (0,01 Mol) 30 %-igem Wasserstoffperoxid versetzt.
Nach 1 h rühren bei 50°C wird mit Toluol verdünnt, mit Sole und gesättigter Natriumcarbonatlösung nachgewaschen, mit Magnesiumsulfat getrocknet und am Rotationsverdampfer eingedampft. Nach Reinigung mittels Chromatographie (Laufmittel: Hexan/Essigester 1:1) erhält man 3,1 g, das sind 68,9 % der Theorie der oben genannten Titelverbindung als gelbes Oel.

| | | | |
|---|---|---|---|
| Elementaranalyse | ber. | C 71,98 % | H 6,94 % |
| | gef. | C 71,45 % | H 7,05 % |

### Beispiel 2 Herstellung von Bis(2-phenylpropyl)-(2,4,6-trimethylbenzoyl)-phosphinoxid.

Das oben genannte Phosphinoxid wird analog zu der in Beispiel 1 beschriebenen Methode hergestellt:

| | | | |
|---|---|---|---|
| Elementaranalyse | ber. | C 77,75 % | H 7,69 % |
| | gef. | C 77,24 % | H 7,72 % |

### Beispiel 3 Herstellung von Diphenyl-[2,2-bis(chlormethyl)propionyl]-phosphinoxid

3,8 g (0,02 Mol) Dichlorpivaloylchlorid werden in 20 ml Toluol vorgelegt und auf 80°C erwärmt. Innerhalb von ca. 5 Minuten werden zu dieser Lösung 4,3 g (0,02 Mol) Methoxydiphenylphosphin zugetropft, wobei Methylchlorid entweicht. Nach 1 h rühren bei 80°C wird die leicht gelbe Lösung auf Raumtemperatur abgekühlt und am Rotationsverdampfer eingedampft. Nach Reinigung durch Chromatographie (Laufmittel: Hexan/Essigester 3:1) erhält man 1,6 g, das sind 22,8 % der Theorie, der oben genannten Verbindung als gelbes Harz.

| | | | | |
|---|---|---|---|---|
| Elementaranalyse | ber. | C 57,48 % | H 4,82 % | Cl 19,96 % |
| | gef. | C 57,37 % | H 5,16 % | Cl 18,84 % |

### Beispiel 4 Herstellung von Ethoxy-(2,6-dimethoxybenzoyl)-(diethoxymethyl)-phosphinoxid

Die Herstellung erfolgt analog zu der in Beispiel 3 beschriebenen Methode.
Man erhält die Verbindung mit einem Schmelzpunkt von 81°C.

| | | | | |
|---|---|---|---|---|
| Elementaranalyse | ber. | C 53,33 % | H 6,99 % | P 8,60 % |
| | gef. | C 53,15 % | H 6,94 % | P 9,24 % |

### Beispiel 5 Herstellung von Diphenyl-[(1,2,2-trimethyl-3-methoxycarbonyl)-cyclopent-1-yl]-phosphinoxid

Die Herstellung erfolgt analog zu der in Beispiel 3 beschriebenen Methode.
Man erhält die Verbindung als Oel in einer Ausbeute von 28,2 % der Theorie.

| | | | |
|---|---|---|---|
| Elementaranalyse | ber. | C 69,33 % | H 6,83 % |
| | gef. | C 68,75 % | H 6,87 % |

### Beispiel 6 Initiator-Reaktivität in einer Weisslack-Dickschicht

Ein Weisslack wird hergestellt aus
- 30 Teilen: ®Ebecryl 608 (Epoxyacrylat der Fa. UCB, Belgien)
- 15 Teilen: Trimethylolpropan-trisacrylat
- 5 Teilen: N-Vinylpyrrolidon
- 50 Teilen: Titandioxid (Rutil).

In den Weisslack werden zwei Gewichtsprozent des zu prüfenden Photoinitiators eingearbeitet und die Formulierung wird in einer Schichtdicke von 100 µm auf Aluminiumbleche, die mit einem weissen Coil-Coat-Lack grundiert sind, aufgetragen.
Die Proben werden unter einer Hg-Mitteldrucklampe (Hanovia, 80 W/cm) durchgehärtet. Die Durchhärtung ist erfolgt, wenn die Unterseite eines abgetrennten Lackfilmes trocken ist Zur Messung der Reaktivität wird die Anzahl der Durchläufe unter der Lampe bei einer bestimmten Bandgeschwindigkeit ermittelt. Die Reaktivität wird ausserdem nach einer Vorbelichtung von einer Minute unter 5 Lampen von 40 W (Philips TL03) gemessen. Die Pendelhärte (nach König, DIN 53157), die Vergilbung (Yellowness-Index, ASTM D1925-70) und der Glanz bei 20° und 60° (Multiglossgerät, ASTM D 523) werden direkt nach der Härtung und nach einer zusätzlichen Bestrahlung von 15 Minuten bzw. 16 h (Glanz) unter 5 Lampen von 40 W (Philips TL03) gemessen.
Die Ergebnisse sind in den Tabellen 1 und 2 wiedergegeben.

**Tabelle 1**

| Weisslack-Dickschicht ohne Vorbelichtung | | | | | | | |
|---|---|---|---|---|---|---|---|
| Verbindung gemäss Beispiel | Wischfestigkeit* | Pendelhärte [sec] | | Yellowness Index | | Glanz (20/60°) | |
| | | sofort | nach 15 Min. | sofort | nach 15 Min. | sofort | nach 16 h |
| 2 | 6 | 43 | 70 | 1,2 | 0,8 | 78/90 | 77/90 |
| 1 | 7 | 36 | 90 | 1,1 | 0,8 | 81/91 | 79/92 |

| | | | | | | | |
|---|---|---|---|---|---|---|---|
| * als Anzahl der Durchläufe bei 20 m/min. | | | | | | | |

**Tabelle 2**

| Weisslack-Dickschicht mit Vorbelichtung | | | | | | | |
|---|---|---|---|---|---|---|---|
| Verbindung gemäss Beispiel | Wischfestigkeit* | Pendelhärte [sec] | | Yellowness Index | | Glanz (20/60°) | |
| | | sofort | nach 15 Min. | sofort | nach 15 Min. | sofort | nach 16 h |
| 1 | 7 | 35 | 76 | 1,6 | 1,2 | 81/91 | 80/91 |
| 2 | 8 | 38 | 56 | 1,8 | 1,4 | 59/89 | 58/89 |

| | | | | | | | |
|---|---|---|---|---|---|---|---|
| * als Anzahl der Durchläufe bei 20 m/min. | | | | | | | |

### Beispiel 7 Initiator-Reaktivität in einem Klarlack

Ein Klarlack wird bereitet aus
- 99,5 Teilen: ®Roskydal UV 502 A (Lösung eines ungesättigten Polyesters in Styrol, Fa. BAYER, BRD)
- 0,5 Teilen: ®Byk 300 (Additiv).

Es werden zwei Gewichtsprozent des zu prüfenden Photoinitiators zugemischt und die Formulierung wird in einer Schichtdicke von 100 µm auf Spanplatten, die mit weissem Kunstharz beschichtet sind, aufgetragen.
Die Proben werden in einem PPG-Bestrahlungsgerät mit Hg-Mitteldrucklampen (2x80 W/cm) bestrahlt. Dabei wird die Bandgeschwindigkeit in m/min ermittelt, die zur Erreichung einer wischfesten Lackoberfläche nötig ist. Die Härte wird durch die Messung der Pendelhärte nach König (DIN 53157) bestimmt und die Vergilbung wird als Yellowness-Index (ASTM D 1925-70) gemessen.
Die Ergebnisse sind in Tabelle 3 wiedergegeben.

**Tabelle 3**

| Verbindung gemäss Beispiel | Wischfestigkeit [Anzahl der Durchläufe bei 20 m/min] | Pendelhärte [sec] | Yellowness Index |
|---|---|---|---|
| 3 | 5 | 82 | 6,6 |
| 5 | 6 | 83 | 6,7 |

## Patentansprüche

1. Eine Verbindung der Formel I, 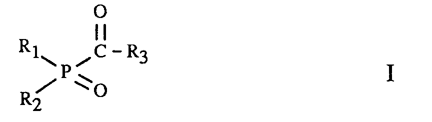 worin R₁ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, einen ein oder mehrere O-, S- oder/und N-Atome enthaltenden 5- oder 6-gliedrigen heterocyclischen einwertigen Rest, der gegebenenfalls einen anellierten Benzorest enthält oder/und der unsubstituiert oder durch C₁-C₄-Alkyl, C₁-C₄-Alkoxy oder/und Halogen substituiert ist oder einen Rest der Formel 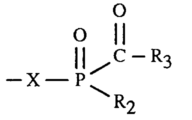 bedeutet, worin X unsubstituiertes oder mit Halogen, C₁-C₄-Alkyl, C₁-C₄-Alkoxy oder Phenyl ein- oder mehrfach substituiertes Phenylen, Xylylen, Cyclohexylen, C₁-C₆-Alkylen, bedeutet,
R₂ einen ein oder mehrere O-, S- oder N-Atome enthaltenden 5- oder 6-gliedrigen heterocyclischen einwertigen Rest, der gegebenenfalls einen anellierten Benzorest enthält oder/und der unsubstituiert oder durch C₁-C₄-Alkyl, C₁-C₄-Alkoxy oder/und Halogen substituiert ist, oder R₁ und R₂ zusammen mit dem Phosphoratom einen mono- oder bi- oder tricyclischen Ring mit 4-15 C-Atomen bilden, oder R₂ -OR₄ bedeutet und R₁ und R₄ zusammen mit dem Phosphoratom einen mono- oder bi- oder tricyclischen Ring mit 4 - 15 C-Atomen bilden,
R₃ C₁-C₁₈-Alkyl, C₂-C₆-Alkenyl, Phenylvinyl, mit Phenyl, C₂-C₅-Alkoxycarbonyl, Halogen, C₁-C₁₂-Alkoxy, Phenoxy, C₁-C₁₂-Alkylthio oder/und Phenylthio ein- oder mehrfach substituiertes C₁-C₈-Alkyl, unsubstituiertes oder durch C₁-C₁₂-Alkyl, Phenyl, Phenoxy, C₁-C₁₂-Alkoxy, C₂-C₅-Alkoxycarbonyl, C₁-C₄-Alkylthio oder/und Halogen substituiertes C₅-C₁₀-Cycloalkyl, unsubstituiertes oder durch C₁-C₁₂-Alkyl, C₁-C₁₂-Alkoxy, C₁-C₁₂-Alkoxyalkyl, C₁-C₄-Alkylthio oder/und Halogen ein- oder mehrfach substituiertes C₆-C₁₂-Aryl oder einen einwertigen 5- oder 6-gliedrigen ein oder mehrere O-, S- oder N-Atome enthaltenden heterocyclischen Rest bedeutet, welcher durch Halogen, C₁-C₄-Alkyl oder C₁-C₄-Alkoxy ein- oder mehrmals substituiert sein kann, und mit der Bestimmung, dass mindestens einer der Reste R₁, R₂ und R₃ ein substituierter Alkylrest ist oder dass R₁ und R₂ zusammen mit dem Phosphoratom einen bi- oder tricyclischen Ring bilden, oder dass R₃ ein substituierter Cycloalkylrest ist der jedoch Alkylreste nicht als alleinige Substituenten enthalten kann.

2. Eine Verbindung gemäss Anspruch 1 der Formel I, worin
R₁ und R₂ oder R₁ und R₄ zusammen mit dem P-Atom einen mono- oder bicyclischen Rest mit 4-8 C-Atomen bilden,
R₃ C₁-C₈-Alkyl, mit Phenyl, C₁-C₄-Alkoxy, C₂-C₅-Alkoxycarbonyl oder/und Chlor ein- oder zweifach substituiertes C₁-C₆-Alkyl, unsubstituiertes oder durch Phenyl, C₁-C₄-Alkoxy, C₂-C₅-Alkoxycarbonyl oder/und Chlor substituiertes C₅-C₆-Cycloalkyl, C₆-C₁₀-Aryl oder durch C₁-C₁₂-Alkyl, C₁-C₄-Alkoxy oder/und Chlor ein- bis dreifach substituiertes C₆-C₁₀-Aryl bedeutet und R₄ C₁-C₈-Alkyl, Cyclohexyl, Benzyl oder Phenyl ist.

3. Eine Verbindung gemäss Anspruch 1 der Formel I, worin
R₁ und R₂ oder R₁ und R₄ zusammen mit dem P-Atom einen mono- oder bicyclischen Ring bilden,
R₃ unsubstituiertes oder durch Phenyl, Chlor oder/und C₁-C₄-Alkoxy substituiertes C₁-C₆-Alkyl, unsubstituiertes oder durch Phenyl, C₁-C₄-Alkoxy, C₂-C₅-Alkoxycarbonyl oder/und Chlor substituiertes C₅-C₆-Cycloalkyl, Phenyl oder durch C₁-C₄-Alkyl, C₁-C₄-Alkoxy oder/und Chlor ein- bis dreifach substituiertes Phenyl bedeutet.

4. Eine Verbindung gemäss Anspruch 1 der Formel I, worin R₁ ein wie in Anspruch 1 definierter substituierter Alkylrest ist.

5. Eine Verbindung gemäss Anspruch 4, worin R₁ durch Phenyl, (C₁-C₄-Alkyl)-phenyl, Chlorphenyl, C₁-C₄-Alkoxy oder Cyano substituiertes C₁-C₄-Alkyl ist.

6. Eine Verbindung gemäss Anspruch 1 der Formel I, worin R₁ Benzyl ist.

7. Eine Verbindung gemäss Anspruch 1 der Formel I, worin R₃ durch C₁-C₄-Alkyl, C₁-C₄-Alkoxy oder Chlor substituiertes Phenyl ist.

8. Eine Verbindung gemäss Anspruch 1 der Formel I, worin R₃ mit Phenyl, C₂-C₅-Alkoxycarbonyl, Halogen oder/und C₁-C₁₂-Alkoxy ein- bis dreifach substituiertes C₁-C₈-Alkyl ist.

9. Eine Verbindung gemäss Anspruch 1 der Formel I, worin R₃ unsubstituiertes oder durch C₁-C₄-Alkyl, Phenyl, Phenoxy, C₁-C₁₂-Alkoxy, C₂-C₅-Alkoxycarbonyl oder/und Halogen substituiertes C₅-C₁₀-Cycloalkyl ist.

10. Eine Verbindung gemäss Anspruch 1 der Formel II oder III, 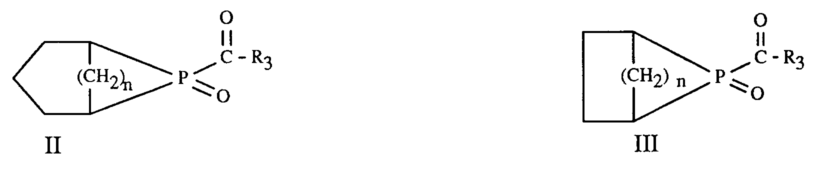 worin n 1-8 ist und R₃ eine der in Anspruch 1 gegebenen Bedeutungen hat.

11. Eine Verbindung gemäss Anspruch 10 der Formel II oder III, worin n 1-8 ist und R₃ durch Phenyl substituiertes C₁-C₄-Alkyl, C₆-C₁₀-Aryl oder durch C₁-C₁₂-Alkyl, C₁-C₄-Alkoxy, oder Chlor ein- bis dreifach substituiertes Phenyl bedeutet.

12. Photopolymerisierbare Zusammensetzung, enthaltend
a) mindestens eine ethylenisch ungesättigte photopolymerisierbare Verbindung und
b) als Photoinitiator mindestens eine Verbindung der Formel I wie in Anspruch 1 definiert.

13. Zusammensetzung gemäss Anspruch 12, dadurch gekennzeichnet, dass sie neben dem Photoinitiator (b) noch einen anderen Photoinitiator und/oder andere Additive enthält.

14. Zusammensetzung gemäss Anspruch 12, enthaltend
0,05 bis 15 Gew.-% der Komponente (b), bezogen auf die Zusammensetzung.

15. Zusammensetzung gemäss Anspruch 12, enthaltend
0,2 bis 5 Gew.-% der Komponente (b), bezogen auf die Zusammensetzung.

16. Verwendung von in Anspruch 1 definierten Verbindungen als Photoinitiatoren für die Photopolymerisation ethylenisch ungesättigter Verbindungen.

17. Verwendung gemäss Anspruch 16 in Kombination mit einem anderen Photoinitiator und/oder anderen Additiven.

18. Zusammensetzung gemäss Anspruch 12, die mindestens einen weiteren Photoinitiator enthält.

19. Verfahren zur Photopolymerisation von nichtflüchtigen monomeren, oligomeren oder polymeren Verbindungen mit mindestens einer ethylenisch ungesättigten Doppelbindung, dadurch gekennzeichnet, dass man zu den oben genannten Verbindungen eine Verbindung der Formel I nach Anspruch 1 zugibt und mit Licht im Bereich von 200 bis 600 nm bestrahlt.

## Patentansprüche (Patentansprüche für folgende(n) Vertragsstaat(en): ES)

1. Photopolymerisierbare Zusammensetzung, enthaltend
a) mindestens eine ethylenisch ungesättigte photopolymerisierbare Verbindung und
b) als Photoinitiator mindestens eine Verbindung der Formel I 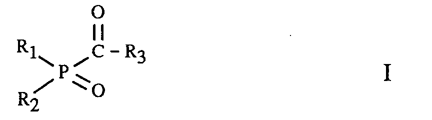 worin R₁ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, einen ein oder mehrere O-, S- oder/und N-Atome enthaltenden 5- oder 6-gliedrigen heterocyclischen einwertigen Rest, der gegebenenfalls einen anellierten Benzorest enthält oder/und der unsubstituiert oder durch C₁-C₄-Alkyl, C₁-C₄-Alkoxy oder/und Halogen substituiert ist oder einen Rest der Formel 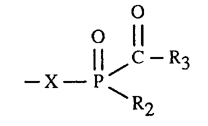 bedeutet, worin X unsubstituiertes oder mit Halogen, C₁-C₄-Alkyl, C₁-C₄-Alkoxy oder Phenyl ein- oder mehrfach substituiertes Phenylen, Xylylen, Cyclohexylen, C₁-C₆-Alkylen, bedeutet,
R₂ einen ein oder mehrere O-, S- oder N-Atome enthaltenden 5- oder 6-gliedrigen heterocyclischen einwertigen Rest, der gegebenenfalls einen anellierten Benzorest enthält oder/und der unsubstituiert oder durch C₁-C₄-Alkyl, C₁-C₄-Alkoxy oder/und Halogen substituiert ist, oder R₁ und R₂ zusammen mit dem Phosphoratom einen mono- oder bi- oder tricyclischen Ring mit 4-15 C-Atomen bilden, oder R₂ -OR₄ bedeutet und R₁ und R₄ zusammen mit dem Phosphoratom einen mono- oder bi- oder tricyclischen Ring mit 4-15 C-Atomen bilden,
R₃ C₁-C₁₈-Alkyl, C₂-C₆-Alkenyl, Phenylvinyl, mit Phenyl, C₂-C₅-Alkoxycarbonyl, Halogen, C₁-C₁₂-Alkoxy, Phenoxy, C₁-C₁₂-Alkylthio oder/und Phenylthio ein- oder mehrfach substituiertes C₁-C₈-Alkyl, unsubstituiertes oder durch C₁-C₁₂-Alkyl, Phenyl, Phenoxy, C₁-C₁₂-Alkoxy, C₂-C₅-Alkoxycarbonyl, C₁-C₄-Alkylthio oder/und Halogen substituiertes C₅-C₁₀-Cycloalkyl, unsubstituiertes oder durch C₁-C₁₂-Alkyl, C₁-C₁₂-Alkoxy, C₁-C₁₂-Alkoxyalkyl, C₁-C₄-Alkylthio oder/und Halogen ein- oder mehrfach substituiertes C₆-C₁₂-Aryl oder einen einwertigen 5- oder 6-gliedrigen ein oder mehrere O-, S- oder N-Atome enthaltenden heterocyclischen Rest bedeutet, welcher durch Halogen, C₁-C₄-Alkyl oder C₁-C₄-Alkoxy ein- oder mehrmals substituiert sein kann, und
mit der Bestimmung, dass mindestens einer der Reste R₁, R₂ und R₃ ein substituierter Alkylrest ist oder dass R₁ und R₂ zusammen mit dem Phosphoratom einen bi- oder tricyclischen Ring bilden, oder dass R₃ ein substituierter Cycloalkylrest ist der jedoch Alkylreste nicht als alleinige Substituenten enthalten kann.

2. Zusammensetzung nach Anspruch 1, worin
R₁ und R₂ oder R₁ und R₄ zusammen mit dem P-Atom einen mono- oder bicyclischen Rest mit 4-8 C-Atomen bilden,
R₃ C₁-C₈-Alkyl, mit Phenyl, C₁-C₄-Alkoxy, C₂-C₅-Alkoxycarbonyl oder/und Chlor ein- oder zweifach substituiertes C₁-C₆-Alkyl, unsubstituiertes oder durch Phenyl, C₁-C₄-Alkoxy, C₂-C₅-Alkoxycarbonyl oder/und Chlor substituiertes C₅-C₆-Cycloalkyl, C₆-C₁₀-Aryl oder durch C₁-C₁₂-Alkyl, C₁-C₄-Alkoxy oder/und Chlor ein- bis dreifach substituiertes C₆-C₁₀-Aryl bedeutet und R₄ C₁-C₈-Alkyl, Cyclohexyl, Benzyl oder Phenyl ist.

3. Zusammensetzung nach Anspruch 1, worin
R₁ und R₂ oder R₁ und R₄ zusammen mit dem P-Atom einen mono- oder bicyclischen Ring bilden,
R₃ unsubstituiertes oder durch Phenyl, Chlor oder/und C₁-C₄-Alkoxy substituiertes C₁-C₆-Alkyl, unsubstituiertes oder durch Phenyl, C₁-C₄-Alkoxy, C₂-C₅-Alkoxycarbonyl oder/und Chlor substituiertes C₅-C₆-Cycloalkyl, Phenyl oder durch C₁-C₄-Alkyl, C₁-C₄-Alkoxy oder/und Chlor ein- bis dreifach substituiertes Phenyl bedeutet.

4. Zusammensetzung nach Anspruch 1, worin R₁ ein wie in Anspruch 1 definierter substituierter Alkylrest ist.

5. Zusammensetzung nach Anspruch 4, worin R₁ durch Phenyl, (C₁-C₄-Alkyl)-phenyl, Chlorphenyl, C₁-C₄-Alkoxy oder Cyano substituiertes C₁-C₄-Alkyl ist.

6. Zusammensetzung nach Anspruch 1 der Formel I, worin R₁ Benzyl ist.

7. Zusammensetzung nach Anspruch 1 der Formel I, worin R₃ durch C₁-C₄-Alkyl, C₁-C₄-Alkoxy oder Chlor substituiertes Phenyl ist.

8. Zusammensetzung nach Anspruch 1 der Formel I, worin R₃ mit Phenyl, C₂-C₅-Alkoxycarbonyl, Halogen oder/und C₁-C₁₂-Alkoxy ein- bis dreifach substituiertes C₁-C₈-Alkyl ist.

9. Zusammensetzung nach Anspruch 1 der Formel I, worin R₃ unsubstituiertes oder durch C₁-C₄-Alkyl, Phenyl, Phenoxy, C₁-C₁₂-Alkoxy, C₂-C₅-Alkoxycarbonyl oder/und Halogen substituiertes C₅-C₁₀-Cycloalkyl ist.

10. Zusammensetzung nach Anspruch 1, dadurch gekennzeichnet, dass sie als Photoinitiator mindestens eine Verbindung der Formel Ia oder Ib, 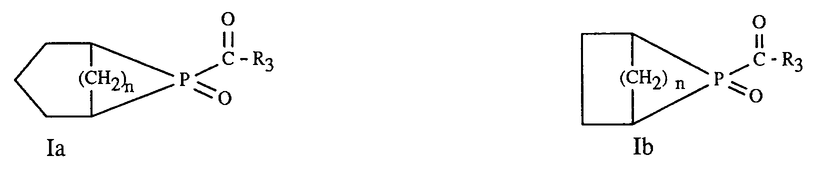 enthält, worin n 1-8 ist und R₃ eine der in Anspruch 1 gegebenen Bedeutungen hat.

11. Zusammensetzung nach Anspruch 10, worin in der Formel Ia oder Ib n 1-8 ist und R₃ durch Phenyl substituiertes C₁-C₄-Alkyl, C₆-C₁₀-Aryl oder durch C₁-C₁₂-Alkyl, C₁-C₄-Alkoxy, oder Chlor ein- bis dreifach substituiertes Phenyl bedeutet.

12. Zusammensetzung gemäss Anspruch 1, dadurch gekennzeichnet, dass sie neben dem Photoinitiator (b) noch einen anderen Photoinitiator und/oder andere Additive enthält.

13. Zusammensetzung gemäss Anspruch 1, enthaltend
0,05 bis 15 Gew.-% der Komponente (b), bezogen auf die Zusammensetzung.

14. Zusammensetzung gemäss Anspruch 1, enthaltend
0,2 bis 5 Gew.-% der Komponente (b), bezogen auf die Zusammensetzung.

15. Verwendung von in Anspruch 1 definierten Verbindungen als Photoinitiatoren für die Photopolymerisation ethylenisch ungesättigter Verbindungen.

16. Verwendung gemäss Anspruch 15 in Kombination mit einem anderen Photoinitiator und/oder anderen Additiven.

17. Zusammensetzung gemäss Anspruch 1, die mindestens einen weiteren Photoinitiator enthält.

18. Verfahren zur Photopolymerisation von nichtflüchtigen monomeren, oligomeren oder polymeren Verbindungen mit mindestens einer ethylenisch ungesättigten Doppelbindung, dadurch gekennzeichnet, dass man zu den oben genannten Verbindungen eine Verbindung der Formel I nach Anspruch 1 zugibt und mit Licht im Bereich von 200 bis 600 nm bestrahlt.

19. Verfahren zur Herstellung von Verbindungen der Formel I 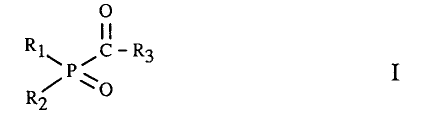 worin R₁ C₁-C₁₈-Alkyl, C₂-C₁₈-Alkenyl, durch Phenyl, (C₁-C₁₂-Alkyl)-phenyl, Halogenphenyl, (C₁-C₁₂-Alkoxy)-phenyl, Cyano, C₂-C₅Alkoxycarbonyl, C₁-C₁₂-Alkoxy oder/und Halogen ein- oder mehrfach substituiertes C₁-C₈-Alkyl, C₅-C₈-Cycloalkyl, C₆-C₁₂-Aryl, durch Halogen, C₁-C₁₂-Alkyl oder/und C₁-C₁₂-Alkoxy ein- oder mehrfach substituiertes C₆-C₁₂-Aryl, einen ein oder mehrere O-, S- oder/und N-Atome enthaltenden 5- oder 6-gliedrigen heterocyclischen einwertigen Rest, der gegebenenfalls einen anellierten Benzorest enthält oder/und der unsubstituiert oder durch C₁-C₄-Alkyl, C₁-C₄-Alkoxy oder/und Halogen substituiert ist oder einen Rest der Formel 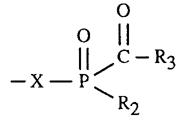 bedeutet, worin X unsubstituiertes oder mit Halogen, C₁-C₄-Alkyl, C₁-C₄-Alkoxy oder Phenyl ein- oder mehrfach substituiertes Phenylen, Xylylen, Cyclohexylen, C₁-C₆-Alkylen, bedeutet,
R₂ einen ein oder mehrere O-, S- oder N-Atome enthaltenden 5- oder 6-gliedrigen heterocyclischen einwertigen Rest, der gegebenenfalls einen anellierten Benzorest enthält oder/und der unsubstituiert oder durch C₁-C₄-Alkyl, C₁-C₄-Alkoxy oder/und Halogen substituiert ist, oder R₁ und R₂ zusammen mit dem Phosphoratom einen mono- oder bi- oder tricyclischen Ring mit 4-15 C-Atomen bilden, oder R₂ -OR₄ bedeutet und R₁ und R₄ zusammen mit dem Phosphoratom einen mono- oder bi- oder tricyclischen Ring mit 4-15 C-Atomen bilden,
R₃ C₁-C₁₈-Alkyl, C₂-C₆-Alkenyl, Phenylvinyl, mit Phenyl, C₂-C₅-Alkoxycarbonyl, Halogen, C₁-C₁₂-Alkoxy, Phenoxy, C₁-C₁₂-Alkylthio oder/und Phenylthio ein- oder mehrfach substituiertes C₁-C₈-Alkyl, unsubstituiertes oder durch C₁-C₁₂-Alkyl, Phenyl, Phenoxy, C₁-C₁₂-Alkoxy, C₂-C₅-Alkoxycarbonyl, C₁-C₄-Alkylthio oder/und Halogen substituiertes C₅-C₁₀-Cycloalkyl, unsubstituiertes oder durch C₁-C₁₂-Alkyl, C₁-C₁₂-Alkoxy, C₁-C₁₂-Alkoxyalkyl, C₁-C₄-Alkylthio oder/und Halogen ein- oder mehrfach substituiertes C₆-C₁₂-Aryl oder einen einwertigen 5- oder 6-gliedrigen ein oder mehrere O-, S- oder N-Atome enthaltenden heterocyclischen Rest bedeutet, welcher durch Halogen, C₁-C₄-Alkyl oder C₁-C₄-Alkoxy ein- oder mehrmals substituiert sein kann, und
R₄ C₁-C₁₈-Alkyl, Phenyl-C₁-C₄-alkyl, C₅-C₈-Cycloalkyl oder C₆-C₁₀-Aryl bedeutet, mit der Bestimmung, dass mindestens einer der Reste R₁, R₂ und R₃ ein substituierter Alkylrest ist oder dass R₁ und R₂ zusammen mit dem Phosphoratom einen bi- oder tricyclischen Ring bilden, oder dass R₃ ein substituierter Cycloalkylrest ist der jedoch Alkylreste nicht als alleinige Substituenten enthalten kann, dadurch gekennzeichnet, dass man primäre oder sekundäre Phosphine der Formel IIa oder IIb
R₁-PH₂ (IIa), 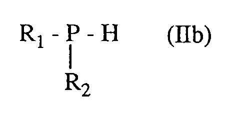
oder Phosphonite der Formel IIIa oder IIIb 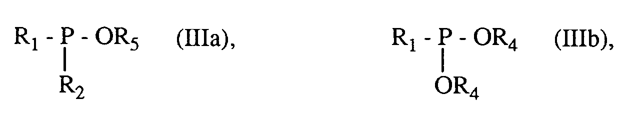 worin R₁, R₂ und R₄ die oben genannte Bedeutung haben und R₅ für ein C₁-C₂₀-Alkyl steht,
mit einem Säurechlorid der Formel IV 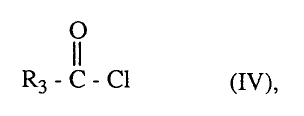 worin R₃ die oben genannte Bedeutung hat, umsetzt und, im Falle dass Verbindungen der Formel IIa oder IIb als Edukte verwendet werden, das Acylierungsprodukt anschliessend oxidiert.

20. Verfahren nach Anspruch 19, worin die Acylierung in Gegenwart einer Base durchgeführt wird.
